# EUROPÄISCHE PATENTSCHRIFT

(11) **EP 0 482 441 B1**
(45) Veröffentlichungstag und Bekanntmachung des Hinweises auf die Patenterteilung: **12.01.1994**
(21) Anmeldenummer: 91117318.5
(22) Anmeldetag: 10.10.1991
(51) Int. Cl.: H03K 17/945, H03K 17/14

(54) **Näherungsschalter mit Kompensation temperaturbedingter Empfindlichkeitsschwankungen**
Proximity switch with compensation of temperature dependent sensitivity instabilities
Commutateur de proximité avec compensation d'instabilités de sensibilité dues à la température

(30) Priorität: 22.10.1990 DE 9014618 U
(43) Veröffentlichungstag der Anmeldung: 29.04.1992
(73) Patentinhaber: SIEMENS AKTIENGESELLSCHAFT, 80333 München (DE)
(72) Erfinder: Schwarz, Robert, Dipl.-Ing. (FH), W-8451 Freudenberg (DE)

(56) Entgegenhaltungen:
- DE-A- 3 643 589
- US-A- 3 707 671
- IBM TECHNICAL DISCLOSURE BULLETIN Bd. 29, Nr. 2, Juli 1986, NEW YORK, US Seiten 935 - 936; 'Proximity Sensor Using a Single Piezoceramic Ultrasonic Transducer'
- HEISS- UND KALTLEITERANWENDUNGEN, 1987,Siemens AG,Seiten 20,21: "Temperaturkompensation mit Heissleitern"

## Beschreibung

Die Erfindung betrifft einen Näherungsschalter mit einem Sendeoszillator und mit einem durch die Sendefrequenz des Sendeoszillators angeregten Wandler mit einer temperaturabhängigen Resonanzfrequenz. Üblicherweise werden die Sendeoszillatoren in Näherungsschaltern mit einer konstanten Sendefrequenz betrieben. Da die Resonanzfrequenz des Wandlers jedoch temperaturabhängig ist, ergeben sich aufgrund von Temperaturschwankungen entsprechend große Abweichungen der Sende- bzw. Empfangsfrequenz von der momentanen Resonanzfrequenz des Wandlers, die Einbußen in der Empfindlichkeit des Näherungsschalters zur Folge haben.

Aus der Publikation "Proximity Sensor Using a Single Piezoceramic Ultrasonic Transducer" (IBM TECHNICAL DISCLOSURE BULLETIN, Bd. 29, Nr. 2, Juli 1986, Seiten 935, 936) ist für einen Näherungsschalter bekannt, die Oszillatorfrequenz der temperaturabhängigen Wandlerfrequenz von der Piezokeramik nachzuführen. Dabei wird die momentane Resonanzfrequenz des Wandlers gemessen und, an diese angepaßt, die Oszillatorfrequenz eines spannungsgeregelten Oszillators über einen Regelkreis geregelt. Die Messung der Wandlerfrequenz und die Anwendung eines zusätzlichen Regelkreises bedeuten jedoch zusätzlichen Aufwand, der bei den kostenoptimierten Geräten in der Praxis nicht gerechtfertigt ist.

Die US-A-3 707 671 befaßt sich damit, die Oszillatorfrequenz bei induktiven Näherungsschaltern mit Hilfe eines Heißleiters unabhängig von Temperaturschwankungen zu linearisieren, d.h. die Oszillatorfrequenz stabil auf einem bestimmten Wert zu halten. Hiervon ausgehend ergibt sich aber das schon oben erwähnte Problem, daß die Wandlerfrequenz ebenfalls temperaturabhängig ist.

Daher besteht die Aufgabe, einen Näherungsschalter herzustellen, dessen Empfindlichkeit bei Temperaturschwankungen auf einfache Weise verbessert ist. Dies wird dadurch gelöst, daß ein Heißleiter vorgesehen ist, mit dem eine temperaturlineare Beeinflussung einer elektrischen Steuergröße erreichbar ist, mit der die Sendefrequenz des Sendeoszillators zur Nachführung der temperaturabhängigen Resonanzfrequenz des Wandlers steuerbar ist. Es erweist sich als günstige und mit wenig Aufwand verbundene Ausgestaltung, wenn der Heißleiter mit seinem einen Anschlußpunkt an Masse liegt und sein anderer Anschlußpunkt über einen ersten ohmschen Widerstand an eine Spannungsquelle angeschlossen ist, wobei an den Verbindungspunkt zwischen dem Heißleiter und dem ersten ohmschen Widerstand ein zweiter ohmscher Widerstand geschaltet ist, dessen anderer Anschlußpunkt an Masse liegt, und daß an den Verbindungspunkt ein dritter ohmscher Widerstand geschaltet ist, dessen anderer Anschlußpunkt mit einem Eingang des Sendeoszillators elektrisch verbunden ist.

Weitere Eingänge des Sendeoszillators sind elektrisch mit Bauteilen verbunden, die zur Frequenzabstimmung des Sendeoszillators dienen.

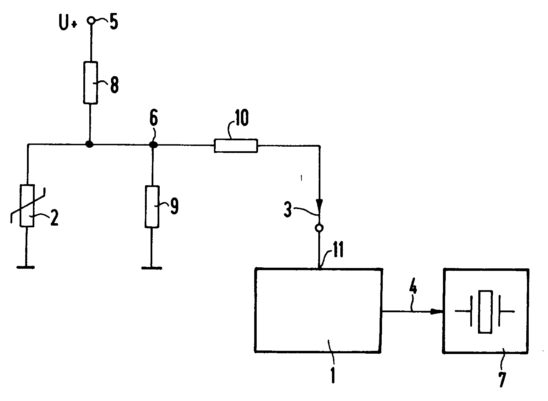

Eine Ausführungsform der Erfindung wird anhand der folgenden Zeichnung näher erläutert. Die Figur zeigt einen Sendeoszillator 1 eines Näherungsschalters. Der Sendeoszillator 1, der z.B. als kundenspezifischer Schaltkreis ausgeführt sein kann, erzeugt über eine Widerstandsschaltung mit einem Heißleiter 2 abhängig von einem Eingangsstrom 3 eine bestimmte Sendefrequenz 4. Durch den Heißleiter 2 erfolgt die Ankoppelung des Sendeoszillators 1 an eine temperaturabhängige Spannungsquelle. Die nicht näher erläuterte Widerstandsbeschaltung mit den ohmschen Widerständen 8 und 9 dient zur Linearisierung der Kennlinie des Heißleiters 2. Der Heißleiter 2 ist über den ohmschen Widerstand 8 an eine Spannungsquelle 5 angeschlossen. Parallel zum Heißleiter 2 liegt der ohmsche Widerstand 9. An den Verbindungspunkt 6 zwischen dem Heißleiter 2 und dem ohmschen Widerstand 8 ist ausserdem der ohmsche Widerstand 10 angeschlossen, dessen anderer Anschlußpunkt am Eingang 11 des Sendeoszillators 1 liegt. Über den Eingang 11 wird mittels des Eingangsstromes 3 die Sendefrequenz 4 des Sendeoszillators 1 gesteuert. Die Anpassung des Steuerstroms 3 an Temperaturschwankungen erfolgt mittels des Heißleiters 2 in Verbindung mit der Widerstandsbeschaltung auf folgende Weise:
Der Heißleiter 2 bildet gemeinsam mit dem Widerstand 8 einen Spannungsteiler für die Spannungsquelle 5. Der zusätzliche Widerstand 9 linearisiert die gekrümmte Kennlinie des Heißleiters 2.
Am Verbindungspunkt 6 liegt eine temperaturabhängige Spannung an, die aufgrund des Verhaltens des Heißleiters 2 bei steigender Temperatur abnimmt.
Die Ankopplung vom Verbindungspunkt 6 zum Eingang 11 des Sendeoszillators 1 über den Widerstand 10 bewirkt eine Spannungs-/Stromwandlung.

Eine Spannungsabnahme am Verbindungspunkt 6 bei steigender Temperatur hat einen geringeren Strom 3 zur Folge, der im Sendeoszillator 1 eine Reduzierung der Sendefrequenz 4 bewirkt. Durch dieses Verhalten wird die Sendefrequenz 4 der temperaturabhängigen Resonanzfrequenz des Wandlers 7 in geeigneter Weise nachgeführt.

## Patentansprüche

1. Näherungsschalter mit einem Sendeoszillator (1), und mit einem durch die Sendefrequenz (4) des Sendeoszillators (1) angeregten Wandler (7) mit einer temperaturabhängigen Resonanzfrequenz, **dadurch** **gekennzeichnet,** daß ein Heißleiter (2) vorgesehen ist, mit dem eine temperaturlineare Beeinflussung einer elektrischen Steuergröße (3) erreichbar ist, mit der die Sendefrequenz (4) des Sendeoszillators (1) der temparaturabhängigen Resonanzfrequenz des Wandlers (7) nachgeführt wird.

2. Näherungsschalter nach Anspruch 1, **dadurch** **gekennzeichnet,** daß der Heißleiter mit seinem einen Anschlußpunkt an Masse liegt und sein anderer Anschlußpunkt über einen ersten ohmschen Widerstand (8) an eine Spannungsquelle (5) angeschlossen ist, wobei an den Verbindungspunkt (6) zwischen dem Heißleiter (2) und dem ersten ohmschen Widerstand (8) ein zweiter ohmscher Widerstand (9) geschaltet ist, dessen anderer Anschlußpunkt an Masse liegt, und daß an den Verbindungspunkt (6) ein dritter ohmscher Widerstand (10) geschaltet ist, dessen anderer Anschlußpunkt mit einem Eingang (11) des Sendeoszillators (1) elektrisch verbunden ist.

## Claims

1. Proximity switch with a transmission oscillator (1), and with a transducer (7) excited by the transmission frequency (4) of the transmission oscillator (1) with a temperature-dependent resonant frequency, characterized in that a negative temperature coefficient (NTC) thermistor (2) is provided, with which a linear influence with respect to temperature of an electrical control variable (3) can be achieved, through which the transmission frequency (4) of the transmission oscillator (1) can be adjusted to the temperature-dependent resonant frequency of the transducer (7).

2. Proximity switch according to claim 1, characterized in that the NTC thermistor is connected to ground with its one terminal and its other terminal is connected by way of a first ohmic resistance (8) to a voltage source (5), wherein there is connected to the connection point (6) between the NTC thermistor (2) and the first ohmic resistance (8) a second ohmic resistance (9), the other terminal of which is connected to ground, and in that there is connected to the connection point (6) a third ohmic resistance (10), the other terminal of which is electrically connected to an input (11) of the transmission oscillator (1).

## Revendications

1. Interrupteur de proximité comportant un oscillateur d'émission (1) et un transducteur (7) excité par la fréquence d'émission (4) de l'oscillateur d'émission (1) et possédant une fréquence de résonance qui dépend de la température, caractérisé par le fait qu'il est prévu une thermistance (2), à l'aide de laquelle on peut influencer, d'une manière linéaire en fonction de la température, une grandeur de commande électrique (3) au moyen de laquelle la fréquence d'émission (4) de l'oscillateur d'émission (1) est asservie à la fréquence de résonance, qui dépend de la température, du transducteur (7).

2. Interrupteur de proximité suivant la revendication 1, caractérisé par le fait que la thermistance est reliée par l'un de ses points de raccordement à la masse et que son autre point de raccordement est relié par l'intermédiaire d'une première résistance ohmique (8) à une source de tension (5), le point de jonction (6) entre la thermistance (2) et la première résistance ohmique (8) étant relié à une seconde résistance ohmique (9), dont l'autre point de raccordement est relié à la masse, et qu'au point de jonction (6) est connectée une troisième résistance ohmique (10), dont l'autre point de raccordement est relié électriquement à une entrée (11) de l'oscillateur d'émission (1).
